(19) Europäisches Patentamt
European Patent Office
Office européen des brevets

(11) Veröffentlichungsnummer: **0 560 130 A1**

# (12) EUROPÄISCHE PATENTANMELDUNG

(21) Anmeldenummer: **93102914.4**

(22) Anmeldetag: **25.02.93**

(51) Int. Cl.[5]: **C08L 77/00**, C08L 77/06, C08G 69/02, C08G 69/26, G03F 7/038

(30) Priorität: **05.03.92 DE 4206949**

(43) Veröffentlichungstag der Anmeldung: **15.09.93 Patentblatt 93/37**

(84) Benannte Vertragsstaaten: **BE CH DE FR GB LI NL**

(71) Anmelder: **BASF Aktiengesellschaft**
**Carl-Bosch-Strasse 38**
**D-67063 Ludwigshafen(DE)**

(72) Erfinder: **Goetz, Walter, Dr.**
**Dhauner Strasse 79**
**W-6700 Ludwigshafen(DE)**
Erfinder: **Gareiss, Brigitte, Dr.**
**Schillerstrasse 65**
**W-6700 Ludwigshafen(DE)**
Erfinder: **Deckers, Andreas, Dr.**
**Eschenbachstrasse 48**
**W-6700 Ludwigshafen(DE)**
Erfinder: **Baierweck, Petra, Dr.**
**Sebastian-Kneipp-Strasse 19**
**W-6707 Schifferstadt(DE)**

## (54) Formmassen auf der Basis ungesättigter Copolyamide.

(57) Formmassen aus

A) 40 bis 100 Gew.-% eines Copolyamids auf der Basis von
  $a_1$) 1 bis 20 Mol-%, bezogen auf das Copolyamid, mindestens eines Monomeren, welches mindestens eine olefinische Doppelbindung enthält (Monomeres $a_1$), aus der Gruppe der
    $\alpha_1$) olefinisch ungesättigten Lactame,
    $\alpha_2$) olefinisch ungesättigten Aminocarbonsäuren,
    $\alpha_3$) olefinisch ungesättigten Dicarbonsäuren,
    $\alpha_4$) olefinisch ungesättigten Diamine und
  $a_2$) 80 bis 99 Mol-%, bezogen auf das Copolyamid, mindestens eines Monomeren, welches keine olefinischen Doppelbindungen enthält (Monomeres $a_2$), aus der Gruppe der
    $\beta_1$) Lactame,
    $\beta_2$) Aminocarbonsäuren,
    $\beta_3$) Dicarbonsäuren,
    $\beta_4$) Diamine und

B) 0 bis 35 Gew.-% eines schlagzäh modifizierenden Kautschuks und
C) 0 bis 50 Gew.-% eines Füllstoffes und/oder eines Verstärkungsmittels und
D) 0 bis 20 Gew.-% eines Flammschutzmittels und
E) 0 bis 5 Gew.-% weiterer Zusatzstoffe und Verarbeitungshilfsmittel.

EP 0 560 130 A1

Die vorliegende Erfindung betrifft Formmassen aus den Komponenten

A) 40 bis 100 Gew.-% eines Copolyamids auf der Basis von

$a_1$) 1 bis 20 Mol-%, bezogen auf das Copolyamid, mindestens eines Monomeren, welches mindestens eine olefinische Doppelbindung enthält (Monomeres $a_1$), aus der Gruppe der

$\alpha_1$) olefinisch ungesättigten Lactame,

$\alpha_2$) olefinisch ungesättigten Aminocarbonsäuren,

$\alpha_3$) olefinisch ungesättigten Dicarbonsäuren,

$\alpha_4$) olefinisch ungesättigten Diamine und

$\alpha_2$) 80 bis 99 Mol-%, bezogen auf das Copolyamid, mindestens eines Monomeren, welches keine olefinischen Doppelbindungen enthält (Monomeres $a_2$), aus der Gruppe der

$\beta_1$) Lactame,

$\beta_2$) Aminocarbonsäuren,

$\beta_3$) Dicarbonsäuren,

$\beta_4$) Diamine und

B) 0 bis 35 Gew.-% eines schlagzäh modifizierenden Kautschuks und

C) 0 bis 50 Gew.-% eines Füllstoffes und/oder eines Verstärkungsmittels und

D) 0 bis 20 Gew.-% eines Flammschutzmittels und

E) 0 bis 10 Gew.-% weiterer Zusatzstoffe und Verarbeitungshilfsmittel.

Ferner betrifft die Erfindung die Verwendung der Formmassen zur Herstellung von Formkörpern, Fasern oder flächigen Gebilden sowie Formkörper, Fasern und flächige Gebilde, die aus den Formmassen erhältlich sind. Weiterhin betrifft die Erfindung ein Verfahren zur Herstellung der Formkörper, Fasern und flächigen Gebilde.

Polyamide, die olefinische Doppelbindungen in der Hauptkette aufweisen sind beispielsweise aus P. Corrachini et al: Europ. Polym. J., 12 (7), 463 (1976), G. Maglio et al: Polymer, 17 (3), 185 (1976) und F. Carriere: Bull. Soc. Chim. Fr. 10, 3965 (1972) bekannt und auf ihre physikalischen Eigenschaften hin untersucht worden.

Aus der DE-AI-39 06 684 ist bekannt, daß aromatische Polyamidharze, die olefinische Doppelbindungen in der Haupt- und/oder in Seitenketten enthalten, durch energiereiche Strahlung vernetzt werden können. Aufgrund ihrer Eigenschaften sind sie jedoch für viele Anwendungszwecke ungeeignet.

Aufgabe der vorliegenden Erfindung war es daher, Formmassen auf Polyamidbasis zur Verfügung zu stellen, die sich zur Herstellung von Formkörpern oder flächigen Gebilden eignen, die problemlos vernetzt werden können und sich durch gleichmäßige Produktqualitäten und insbesondere durch hohe Wärmeformbeständigkeit auszeichnen.

Die Aufgabe wurde durch die erfindungsgemäßen Formmassen auf der Basis von Copolyamiden, die olefinische Doppelbindungen enthalten, gelöst.

Erfindungsgemäß bestehen diese Formmassen aus 40 bis 100 Gew.-%, vorzugsweise aus 50 bis 90, insbesondere aus 60 bis 80 Gew.-%, bezogen auf das Gesamtgewicht der Formmassen, dieser olefinische Doppelbindungen enthaltenden Copolyamiden (Komponente (A)), von 0 bis 35 Gew.-%, vorzugsweise von 5 bis 25, insbesondere von 10 bis 20 Gew.-%, bezogen auf das Gesamtgewicht der Formmassen, eines schlagzähmodifizierenden Kautschuks (Komponente (B)), von 0 bis 50 Gew.-%, bevorzugt von 10 bis 40, insbesondere 15 bis 35, bezogen auf das Gesamtgewicht der Formmassen, an Füllstoffen und Verstärkungsmitteln (Komponente (C)), von 0 bis 20 Gew.-%, bevorzugt von 5 bis 20 Gew.-%, insbesondere 5 bis 15 Gew.-%, bezogen auf das Gesamtgewicht der Formmassen, eines Flammschutzmittels (Komponente (D)) und 0 bis 10 Gew.-%, bevorzugt 0 bis 5 Gew.-%, insbesondere 0,5 bis 2 Gew.-%, bezogen auf das Gesamtgewicht der Formmassen, weiteren Zusatzstoffen und Hilfsmitteln (Komponente (E)).

Die Copolyamide (A) sind aufgebaut auf der Basis von 1 bis 20 Mol-%, bevorzugt 2 bis 15 mol-%, insbesondere 2 bis 10 mol-%, bezogen auf die Komponente (A), mindestens eines Monomeren ($a_1$), welches mindestens eine olefinische Doppelbindung hat und der Gruppe der jeweils olefinisch ungesättigten Lactame, Aminocarbonsäuren, Dicarbonsäuren und Diamine angehört. Im allgemeinen haben diese ungesättigten Monomeren nicht mehr als fünf, insbesondere nicht mehr als drei olefinische Doppelbindungen, die vorteilhaft nicht in Konjugation zueinander stehen. Neben olefinischen Doppelbindungen können die Monomeren ($a_1$) auch aromatische Doppelbindungen aufweisen, wobei die olefinischen und aromatischen Doppelbindungen vorteilhaft nicht konjugiert zueinander stehen. Neben aromatischen Ringen können die Monomeren ($a_1$) auch cycloaliphatische Ringe enthalten. Verbindungen, die eine Doppelbindung in $\alpha$-Stellung zur Carbonylfunktion enthalten, sind dabei als Monomere ($a_1$) weniger geeignet. Aliphatische Verbindungen mit 6 oder mehr Kohlenstoffatomen, die eine Doppelbindung in $\alpha$-Stellung zur Carbonylfunktion enthalten, können jedoch als Monomere ($\alpha$) geeignet sein.

Zu den olefinisch ungesättigten Lactamen ($\alpha_1$), die im allgemeinen 6 bis 12, insbesondere 6 bis 7 Kohlenstoffatome aufweisen, zählen 3-Hexensäurelactam, 4-Hexensäurelactam, 5-Hexensäurelactam, 3-Heptensäurelactam, 4-Heptensäurelactam, 5-Heptensäurelactam, 6-Heptensäurelactam, 5-Methyl-4-pentensäurelactam. Selbstverständlich können auch Mischungen verschiedener ungesättigter Lactame eingesetzt werden.

Die in Betracht kommenden olefinisch ungesättigten Aminocarbonsäuren ($\alpha_2$) haben im allgemeinen 6 bis 20, insbesondere 6 bis 7 Kohlenstoffatome. Beispiele für diese Verbindungen sind 6-Amino-3-hexensäure, 16-Amino-9-hexadecensäure, 18-Amino-9,12-octadecadiensäure, 20-Amino-9-eicosensäure. Daneben kommen auch Mischungen unterschiedlicher ungesättigter Amino-carbonsäuren in Betracht.

Erfindungsgemäß können auch olefinisch ungesättigte Dicarbonsäuren ($\alpha_3$) eingesetzt werden. In der Regel haben diese 6 bis 30 Kohlenstoffatome. Bevorzugt werden Dicarbonsäuren mit 8 bis 30 Kohlenstoffatomen verwendet. Diese Dicarbonsäuren können sowohl linear als auch verzweigt sein, wobei lineare aliphatische Dicarbonsäuren bevorzugt werden. Als Vertreter sind beispielsweise 2-Hexen-1,6-dicarbonsäure, 3-Hexen-1,6-dicarbonsäure, 4-Octen-1,8-dicarbonsäure und 5-Carboxy-9-decensäure zu nennen. Besonders bevorzugt sind langkettige Dicarbonsäuren mit 12 bis 30 Kohlenstoffatomen, die z.B. mittels Metathesereaktionen aus Fettsäureestern erhältlich sind. Darunter sind 9-Octadecen-1,18-dicarbonsäure (z.B. aus Ölsäure herstellbar) und die beispielsweise aus Ricinolsäure erhältliche 10-Eicosen-1,20-dicarbonsäure. Daneben kommen auch die beispielsweise aus Öl-, Linol-, Linolensäure-Gemischen herstellbaren 9,12-Tetracosadien-1,24-dicarbonsäure,9,12-Heneicosadien-1,21-dicarbonsäure, 9,12, 15-Tetracosatrien-1,24-dicarbonsäure, 9,12,15,18-Heptacosatetraen-1,24-dicarbonsäure sowie die z.B. aus Öl-, Ricinolsäure-Gemischen zugänglichen 9-Nonadecen-1,19-dicarbonsäure, 9,12-Docasadien-1,22-dicarbonsäure und 9,12, 15-pentacosatrien-1,25-dicarbonsäure in Betracht. Eine bevorzugte ungesättigte Dicarbonsäure ist 9-Octadecen-1,18-dicarbonsäure. Ganz besonders werden 3-Hexen-1,6-dicarbonsäure, 4-Octen-1,8-dicarbonsäure und 10-Eicosen-1,20-dicarbonsäure bevorzugt. Es können sowohl Einzelverbindungen als auch Gemische unterschiedlicher ungesättigter Dicarbonsäuren verwendet werden.

Als Monomere ($a_1$) eignen sich erfindungsgemäß auch olefinisch ungesättigte Diamine ($\alpha_4$). Diese Diamine können sowohl linear als auch verzweigt sein. Diese haben im allgemeinen 4 bis 20, bevorzugt 6 bis 18, insbesondere 6 bis 12 Kohlenstoffatome und gehören z.B. zu der Gruppe 1,4-Diamino-2-buten, 1,5-Diamino-2-penten, 1,6-Diamino-2-hexen, 1,6-Diamino-3-hexen, 2,7-Diamino-2,7-dimethyl-4-octen, 1,9-Diamino-2,7-nonadien, 1,10-Diamino-2,8-decadien. Bevorzugte ungesättigte Diamine sind 1,6-Diamino-2-hexen, 1,6-Diamino-3-hexen sowie 2,7-Diamino-2,7-dimethyl-4-octen. Ferner können Mischungen unterschiedlicher ungesättigter Diamine verwendet werden.

Die in den erfindungsgemäßen Formmassen enthaltenden Copolyamide (A) enthalten 80 bis 99 mol-%, bevorzugt 85 bis 98 mol-%, insbesondere von 90 bis 98 mol-%, bezogen auf die Komponente (A), an Einheiten, die sich von Monomeren ($\beta$) ableiten, welche keine olefinischen Doppelbindungen aufweisen. Die Monomeren ($\beta$) können jedoch aromatische Doppelbindungen haben. Als Monomere ($\beta$) kommen Verbindungen aus der Gruppe der Lactame, Aminocarbonsäuren, Dicarbonsäuren und Diamine oder Mischungen derselben in Betracht.

Die Lactame ($\beta_1$) haben im allgemeinen 5 bis 12 Kohlenstoffatome. Vertreter dieser Monomeren sind $\delta$-Valerolactam, $\epsilon$-Caprolactam, Önantholactam, Capryllactam und Laurinlactam. Neben den Einzelverbindungen eignen sich auch Gemische zweier oder mehrerer verschiedener Lactame.

Aminocarbonsäuren ($\beta_2$) mit im allgemeinen 4 bis 20, bevorzugt 5 bis 12 Kohlenstoffatomen wie 5-Aminopentansäure, 6-Aminohexansäure, 7-Aminoheptansäure, 8-Aminooctansäure, 11-Aminoundecansäure sowie Mischungen unterschiedlicher Aminocarbonsäuren sind ebenfalls als Monomere ($\beta$) geeignet.

Zu den Dicarbonsäuren ($\beta_3$) zählen sowohl aromatische als auch aliphatische. Aromatische Dicarbonsäuren haben vorzugsweise 8 bis 16, insbesondere 8 bis 10 Kohlenstoffatome und sind beispielsweise Isophthalsäure, Terephthalsäure, substituierte Isophthalsäuren und Terephthalsäuren wie 3-t-Butylisophthalsäure oder Phenoxyterephthalsäure, mehrkernige Dicarbonsäuren, z.B. 4,4'-Diphenyldicarbonsäure, 3,3'-Diphenyldicarbonsäure, 3,3'-Diphenylmethandicarbonsäure, 4,4'-Diphenylmethandicarbonsäure, 3,3'-Diphenylsulfondicarbonsäure, 4,4'-Diphenylsulfondicarbonsäure, 1,4-Naphthalindicarbonsäure, 2,6-Naphthalindicarbonsäure, wobei Terephthalsäure und Isophthalsäure besonders bevorzugt sind. Vertreter der aliphatischen Dicarbonsäuren, die in der Regel 4 bis 20 Kohlenstoffatome, vorteilhafterweise 6 bis 16 Kohlenstoffatome aufweisen, sind Adipinsäure, Suberinsäure, Azelainsäure$_1$ Sebacinsäure und 1, 12-Dodecansäure. Besonders bevorzugt ist Adipinsäure. Es können aber auch Mischungen unterschiedlicher Dicarbonsäuren verwendet werden.

Geeignete Diamine ($\beta_4$) haben in der Regel 4 bis 20, vorzugsweise 6 bis 12 Kohlenstoffatome. 1,4-Diaminobutan, 1,5-Diaminopentan, 1,6-Diaminohexan, Piperazin, 4,4'-Diaminodicyclohexylmethan, 2,2-(4,4'-Diaminodicyclohexyl)propan und 3,3'-Dimethyl-4,4'-diaminodicyclohexylmethan sind Beispiele für Diamine,

die als Monomere B verwendet werden können. Außer den aliphatischen und cycloaliphatischen Diaminen kommen auch aromatische Ringe enthaltende Diamine wie m-Xylylendiamin in Betracht. Daneben eignen sich auch Mischungen aus zwei oder mehr unterschiedlichen Diaminen.

Die erfindinngsgemäßen Copolyamide können durch Kombinieren unterschiedlicher Monomerer ($\alpha$) und ($\beta$) hergestellt werden. Dabei versteht es sich, daß die Amin- und Carbonsäureäquivalente etwa im Verhältnis 1:1 eingesetzt werden sollten. Beispiele für derartige Mischungen sind

- olefinisch ungesättigte Lactame ($\alpha_1$) mit Lactamen ($\beta_1$)
- olefinisch ungesättigte Dicarbonsäuren ($\alpha_3$) mit Diaminen ($\beta_4$)
- olefinisch ungesättigte Diamine ($\alpha_4$) mit Dicarbonsäuren ($\beta_3$).

Besonders bevorzugt sind die Mischungen

- olefinisch ungesättigte Dicarbonsäuren ($\alpha_3$) mit Dicarbonsäuren ($\beta_3$) und mit Diaminen ($\beta_4$)
- olefinisch ungesättigte Dicarbonsäuren ($\alpha_3$) mit Lactamen ($\beta_1$) und mit Diaminen ($\beta_4$).

Ganz besonders bevorzugt sind die beiden letztgenannten Mischungen, wenn als ($\beta_1$) $\epsilon$-Caprolactam, als ($\beta_3$) Adipinsäure und als ($\beta_4$) 1,6-Diaminohexan verwendet wird.

Bevorzugte olefinisch ungesättigte Dicarbonsäuren ($\alpha_3$) sind in diesen Mischungen 3-Hexendicarbonsäure, 4-Octendicarbonsäure oder 10-Eicosendicarbonsäure. Bevorzugte Mischungen enthalten ferner olefinisch ungesättigte Diamine ($\alpha_4$), insbesondere 1,6-Diamino-3-hexen oder 2,7-Diamino-2,7-dimethyl-4-octen oder deren Mischungen.

Zur Herstellung der Copolyamide (Komponente A) eignen sich sowohl diskontinuierliche als auch kontinuierliche Verfahren. Zur Herstellung von Homo- oder Copolyamiden, die neben olefinischen Doppelbindungen auch aromatische Einheiten aufweisen und deren Einheiten ganz oder teilweise aus Dicarbonsäuren erhältlich sind, haben sich Verfahren, als besonders vorteilhaft erwiesen, bei denen unter erhöhtem Druck und Temperaturen zwischen ca. 200 und 400 °C innerhalb kurzer Verweilzeiten zunächst Präpolymere hergestellt werden, die anschließend in fester Phase oder in der Schmelze auf Endviskosität nachkondensiert werden. Durch die kurzen Verweilzeiten können Nebenreaktionen wie Selbstkondensation von Diaminen zu Triaminen zurückgedrängt werden.

Die gegebenenfalls in bis zu 35 Gew.-%, insbesondere 10 bis 20 Gew.-%, vorhandene Kautschukkomponente (B) der Formmassen ist vorzugsweise in 5 bis 25 Gew.-%, bezogen auf das Gesamtgewicht der Formmassen, in diesen enthalten. Im allgemeinen handelt es sich bei dieser Kautschukkomponente (B) um Copolymerisate, die bevorzugt aus mindestens zwei der folgenden Monomeren als Hauptkomponenten aufgebaut sind: Ethylen, Propylen, Isobuten, Isopren, Chloropren, Vinylacetat, Styrol, Acrylnitril und Acryl- und Methacrylsäureestern mit 1 bis 18 C-Atomen in der Alkoholkomponente.

Kautschuke dieser Art sind z.B. in Houben-Weyl, Methoden der organischen Chemie, Bd. 14/1 (Thieme-Verlag, Stuttgart, 1961), Seiten 392 bis 406 und in der Monographie von C.B. Bucknall, "Toughened Plastic" (Applied Science Publishers, London, 1977) beschrieben.

Bevorzugte Arten von solchen Elastomeren sind die sog. Ethylen-Propylen (EPM) bzw. Ethylen-Propylen-Dien-(EPDM)Kautschuke, die vorzugsweise ein Verhältnis von Ethyleneinheiten zu Propyleneinheiten im Bereich von 40:60 bis 90:10 aufweisen.

Die Mooney-Viskositäten (MLI + 4/100 °C) solcher unvernetzten EPM bzw. EPDM-Kautschuke (Gelgehalte im allgemeinen unter 1 Gew.%) liegen bevorzugt im Bereich von 25 bis 100, insbesondere von 35 bis 90 (gemessen am großen Rotor nach 4 Minuten Laufzeit bei 100 °C nach DIN 53 523).

EPM-Kautschuke haben im allgemeinen praktisch keine Doppelbindungen mehr, während EPDM-Kautschuke 1 bis 20 Doppelbindungen/100 C-Atome aufweisen können.

Als Dien-Monomere für EPDM-Kautschuke seien beispielsweise konjugierte Diene wie Isopren, nicht-konjugierte Diene mit 5 bis 25 C-Atomen wie Penta-1,4-dien, Hexa-1,4-dien, Hexa-1,5-dien, 2,5-Dimethylhexa-1,5-dien und Octa-1,4-dien, cyclische Diene wie Cyclopentadien, Cyclohexadiene, Cyclooctadiene und Dicyclopentadien sowie Alkenylnorbornene wie 5-Ethyliden-2-norbornen, 5-Butyliden-2-norbornen, 2-Methallyl-5-norbornen, 2-Isopropenyl-5-norbornen und Tricyclodiene wie 3-Methyl-tricyclo(5.2.1.0.2.6)-3,8-decadien oder deren Mischungen genannt. Bevorzugt werden Hexa-1,5-dien-5-Ethyliden-norbornen und Dicyclopentadien. Der Diengehalt der EPDM-Kautschuke beträgt vorzugsweise 0,5 bis 50, insbesondere 1 bis 8 Gew.-%, bezogen auf das Gesamtgewicht des Kautschuks.

EPM- bzw. EPDM-Kautschuke können vorzugsweise auch mit reaktiven Carbonsäuren oder deren Derivaten gepfropft sein. Hier seien z.B. Acrylsäure, Methacrylsäure und deren Derivate sowie Maleinsäureanhydrid genannt.

Eine weitere Gruppe bevorzugter Kautschuke sind Copolymere des Ethylens mit Acrylsäure und/oder Methacrylsäure und/oder den Estern dieser Säuren. Zusätzlich können die Kautschuke noch Dicarbonsäuren wie Maleinsäure und Fumarsäure oder Derivate dieser Säuren, z.B. Ester und Anhydride, und/oder Epoxy-Gruppen enthaltende Monomere enthalten. Diese Dicarbonsäurederivate bzw. Epoxygruppen enthaltende Monomere werden vorzugsweise durch Zugabe von Dicarbonsäure- bzw. Epoxygruppen enthaltenden Monomeren der allgemeinen Formeln II oder III oder IV oder V zum Monomerengemisch in den Kautschuk eingebaut

$R_1C(COOR_2) = C(COOR_3)R_4$ II

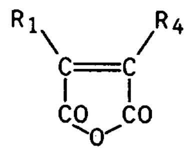

III

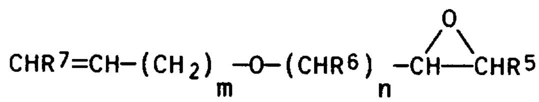

IV

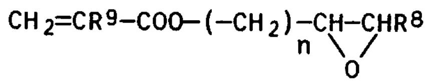

V

wobei $R^1$ bis $R^9$ Wasserstoff oder Alkylgruppen mit 1 bis 6 C-Atomen darstellen und m eine ganze Zahl von 0 bis 20, n eine ganze Zahl von 0 bis 10 und p eine ganze Zahl von 0 bis 5 ist.

Vorzugsweise bedeuten die Reste $R^1$ bis $R^7$ Wasserstoff, wobei m für 0 oder 1 und n für 1 steht. Die entsprechenden Verbindungen sind Maleinsäure, Fumarsäure, Maleinsäureanhydrid, Allylglycidylether und Vinylglycidylether.

Bevorzugte Verbindungen der Formeln II, III und V sind Maleinsäure, Maleinsäureanhydrid und Epoxygruppen-enthaltende Ester der Acrylsäure und/oder Methacrylsäure, wobei Glycidylacrylat, Glycidylmethacrylat und die Ester mit tertiären Alkoholen, wie t-Butylacrylat besonders bevorzugt werden. Letztere weisen zwar keine freien Carboxylgruppen auf, kommen in ihrem Verhalten aber den freien Säuren nahe und werden deshalb als Monomere mit latenten Carboxylgruppen bezeichnet.

Der Ethylengehalt der Copolymeren liegt im allgemeinen im Bereich von 50 bis 98 Gew.-%, und der Anteil an Methacrylsäureestern zwischen 2 und 50 Gew.-%. Vorteilhaft bestehen die Copolymeren aus 50 bis 98 Gew.-% Ethylen, 0,1 bis 20 Gew.-% Epoxygruppen enthaltenden Monomeren und/oder Methacrylsäure und/oder Säureanhydridgruppen enthaltenden Monomeren sowie der restlichen Menge an Methacrylsäureestern.

Besonders bevorzugt sind Copolymerisate aus

50 bis 98, insbesondere 60 bis 95 Gew.-% Ethylen,

0,1 bis 40, insbesondere 0,3 bis 20 Gew.-% Glycidylacrylat und/oder Glycidylmethacrylat, Acrylsäure und/oder Maleinsäureanhydrid, und

1 bis 45, insbesondere 10 bis 35 Gew.-% n-Butylacrylat und/oder 2-Ethylhexylacrylat.

Weitere bevorzugte Ester der Acryl- und/oder Methacrylsäure sind die Methyl-, Ethyl-, Propyl- und i- bzw. t-Butylester.

Daneben können auch Vinylester und Vinylether als Comonomere eingesetzt werden.

Die vorstehend beschriebenen Ethylencopolymeren können nach an sich bekannten Verfahren hergestellt werden, vorzugsweise durch statistische Copolymerisation unter hohem Druck und erhöhter Temperatur. Entsprechende Verfahren sind allgemein bekannt.

Der Schmelzindex der Ethylencopolymeren liegt im allgemeinen im Bereich von 1 bis 80 g/10 min (gemessen bei 190 °C und 2,16 kg Belastung).

Weitere bevorzugte Elastomere (B) sind Emulsionspolymerisate, deren Herstellung z.B. in Houben-Weyl, Methoden der organischen Chemie, Band XII. I (1961) sowie bei Blackley in der Monographie "Emulsion Polymerization" beschrieben wird. Die verwendbaren Emulgatoren und Katalystoren sind an sich bekannt.

Grundsätzlich können homogen aufgebaute Elastomere oder aber solche mit einem Schalenaufbau eingesetzt werden. Der schalenartige Aufbau wird durch die Zugabereihenfolge der einzelnen Monomeren bestimmt; auch die Morphologie der Polymeren wird von dieser Zugabereihenfolge beeinflußt.

Nur stellvertretend seien hier als Monomere für die Herstellung des Kautschukteils der Elastomeren Acrylate wie n-Butylacrylat und 2-Ethylhexylacrylat, entsprechende Methacrylate und Isopren sowie deren

Mischungen genannt. Diese Monomeren können mit weiteren Monomeren wie Styrol, Acrylnitril, Vinylethern und weiteren Acrylaten oder Methacrylaten wie Methylmethacrylat, Methylacrylat, Ethylacrylat und Propylacrylat copolymerisiert werden.

Die Weich- oder Kautschukphase (mit einer Glasübergangstemperatur von unter 0 °C) der Elastomeren kann den Kern, die äußere Hülle oder eine mittlere Schale (bei Elastomeren mit mehr als zweischaligem Aufbau) darstellen; bei mehrschaligen Elastomeren können auch mehrere Schalen aus einer Kautschukphase bestehen.

Sind neben der Kautschukphase noch eine oder mehrere Hartkomponenten (mit Glasübergangstemperaturen von mehr als 20 °C) am Aufbau des Elastomeren beteiligt, so werden diese im allgemeinen durch Polymerisation von Styrol, Acrylnitril, Methacrylnitril, α-Methylstyrol, p-Methylstyrol, Acrylsäureestern und Methacrylsäureestern wie Methylacrylat, Ethylacrylat und Methylmethacrylat als Hauptmonomeren hergestellt. Daneben können auch hier geringere Anteile an weiteren Comonomeren eingesetzt werden.

In einigen Fällen hat es sich als vorteilhaft herausgestellt, Emulsionspolymerisate einzusetzen, die an der Oberfläche reaktive Gruppen aufweisen. Derartige Gruppen sind z.B. Epoxy-, Carboxyl-, latente Carboxyl-, Amino- oder Amidgruppen sowie funktionelle Gruppen, die durch Mitverwendung von Monomeren der allgemeinen Formel VI

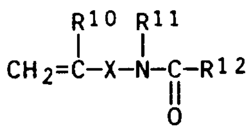

VI

eingeführt werden können,
wobei die Substituenten folgende Bedeutung haben können:

- $R^{10}$ Wasserstoff oder eine $C_1$- bis $C_4$-Alkylgruppe,
- $R^{11}$ Wasserstoff, eine $C_1$- bis $C_8$-Alkylgruppe oder eine Arylgruppe, insbesondere Phenyl,
- $R^{12}$ Wasserstoff, eine $C_1$- bis $C_{10}$-Alkyl-, eine $C_6$-$C_{12}$-Arylgruppe oder -$OR^{13}$,
- $R^{13}$ eine $C_1$- bis $C_8$-Alkyl- oder $C_6$- bis $C_{12}$-Arylgruppe, die gegebenenfalls mit O- oder N-haltigen Gruppen substituiert sein können,
- X eine chemische Bindung, eine $C_1$- bis $C_{10}$-Alkylen- oder $C_6$- bis $C_{12}$-Arylengruppe oder

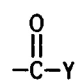

- Y O-Z- oder NH-Z und
- Z eine $C_1$- bis $C_{10}$-Alkylen- oder $C_6$- bis $C_{12}$-Arylengruppe.

Auch die in der EP-A 208 187 beschriebenen Pfropfmonomeren sind zur Einführung reaktiver Gruppen an der Oberfläche geeignet.

Als weitere Beispiele seien noch Acrylamid, Methacrylamid und substituierte Ester der Acrylsäure oder Methacrylsäure wie (N-t-Butylamino)-ethylmethacrylat, (N,N-Dimethylamino)ethylacrylat, (N,N-Dimethylamino)-methylacrylat und (N,N-Diethylamino)ethylacrylat genannt.

Weiterhin können die Teilchen der Kautschukphase auch vernetzt sein. Als Vernetzer wirkende Monomere sind beispielsweise Divinylbenzol, Diallylphthalat und Dihydrodicyclopentodienylacrylat sowie die in der EP-A 50 265 beschriebenen Verbindungen zu nennen.

Ferner können auch sogenannten pfropfvernetzende Monomere (graft-linking monomers) verwendet werden, d.h. Monomere mit zwei oder mehr polymerisierbaren Doppelbindungen, die bei der Polymerisation mit unterschiedlichen Geschwindigkeiten reagieren. Vorzugsweise werden solche Verbindungen verwendet, in denen mindestens eine reaktive Gruppe mit etwa gleicher Geschwindigkeit wie die übrigen Monomeren polymerisiert, während die andere reaktive Gruppe (oder reaktive Gruppen) z.B. deutlich langsamer polymerisiert (polymerisieren). Die unterschiedlichen Polymerisationsgeschwindigkeiten bringen einen bestimmten Anteil an ungesättigten Doppelbindungen im Kautschuk mit sich. Wird anschließend auf einen solchen Kautschuk eine weitere Phase aufgepfropft, so reagieren die im Kautschuk vorhandenen Doppelbindungen zumindest teilweise mit den Pfropfmonomeren unter Ausbildung von chemischen Bindungen, d.h. die aufgepfropfte Phase ist zumindest teilweise über chemische Bindungen mit der Pfropfgrundlage verknüpft.

Beispiele für solche pfropfvernetzende Monomere sind Allylgruppen enthaltende Monomere, insbesondere Allylester von ethylenisch ungesättigten Carbonsäuren wie Allylacrylat, Allylmethacrylat, Diallylmaleat, Diallylfumarat, Diallylitaconat oder die entsprechenden Monoallylverbindungen dieser Dicarbonsäuren. Daneben gibt es eine Vielzahl weiterer geeigneter pfropfvernetzender Monomerer; für nähere Einzelheiten sei hier beispielsweise auf die US-PS 4 148 846 verwiesen.

Im allgemeinen beträgt der Anteil dieser vernetzenden Monomeren an der Komponente (B) bis zu 5 Gew.-%, vorzugsweise nicht mehr als 3 Gew.-%, bezogen auf (B).

Nachfolgend seien einige bevorzugte Emulsionspolymerisate aufgeführt. Zunächst sind hier Pfropfpolymerisate mit einem Kern und mindestens einer äußeren Schale zu nennen, die folgenden Aufbau haben:

| Typ | Monomere für den Kern | Monomere für die Hülle |
|---|---|---|
| $M_1$ | Isopren, n-Butylacrylat, Ethylhexylacrylat oder deren Mischungen | Styrol, Acrylnitril, Methylmethacrylat |
| $M_2$ | wie $M_1$ aber unter Mitverwendung von Vernetzern | wie $M_1$ |
| $M_3$ | wie $M_1$ oder $M_2$ | n-Butylacrylat, Ethylacrylat, Methylacrylat, Isopren, Ethylhexylacrylat |
| $M_4$ | wie $M_1$ oder $M_2$ | wie $M_1$ oder $M_3$ aber unter Mitverwendung von Monomeren mit reaktiven Gruppen wie hierin beschrieben |
| $M_5$ | Styrol, Acrylnitril, Methylmeth acrylat oder deren Mischungen | erste Hülle aus Monomeren wie unter $M_1$ und $M_2$ für den Kern beschrieben zweite Hülle wie unter $M_1$ oder $M_3$ für die Hülle beschrieben |

Anstelle von Pfropfpolymerisaten mit einem mehrschaligen Aufbau können auch homogene, d.h. einschalige Elastomere aus Isopren und n-Butylacrylat oder deren Copolymeren eingesetzt werden. Auch diese Produkte können durch Mitverwendung von vernetzenden Monomeren oder Monomeren mit reaktiven Gruppen hergestellt werden.

Beispiele für bevorzugte Emulsionspolymerisate sind n-Butylacrylat/(Meth)acrylsäure-Copolymere, n-Butylacrylat/Glycidylacrylat- oder n-Butylacrylat/Glycidylmethacrylat-Copolymere, Pfropfpolymerisate mit einem inneren Kern aus n-Butylacrylat und einer äußeren Hülle aus den vorstehend genannten Copolymeren und Copolymere von Ethylen mit Comonomeren, die reaktive Gruppen liefern.

Die beschriebenen Elastomere (B) können auch nach anderen üblichen Verfahren, z.B. durch Suspensionspolymerisation, hergestellt werden.

Selbstverständlich können auch Mischungen der vorstehend aufgeführten Kautschuktypen eingesetzt werden können.

Die erfindinngsgemäßen Formmassen können 0 bis 50 Gew.-%, bevorzugt 10 bis 40 Gew.-%, insbesondere von 15 bis 35 Gew.-%, bezogen auf das Gesamtgewicht der Formmassen, an faser- oder teilchenförmigen Füllstoffen oder Verstärkungsmitteln oder Mischungen solcher Materialien als Komponente (C) enthalten.

Als faserförmige Füllstoffe seien hier nur beispielsweise Glasfasern, Kohlenstoff-Fasern, Aramid-Fasern, Kaliumtitanatfasrn und faserförmige Silikate wie Wollastonit genannt. Besonders bevorzugt werden Glasfasern und Wollastonit verwendet.

Bei der Verwendung von Kohlenstoff- oder Glasfasern können diese zur besseren Verträglichkeit mit dem Copolyamid mit einer Schlichte und einem Haftvermittler ausgerüstet sein.

Im allgemeinen haben die verwendeten Glasfasern einen Durchmesser im Bereich von 6 bis 20 $\mu$m. Da sich beim Verarbeiten die mittlere Faserlänge der Glasfasern verkürzt, kann die Einarbeitung der Glasfasern sowohl in Form von Endlossträngen (Rovings) als auch Schnittglasfasern mit einer Länge von im allgemeinen 1 bis 10 mm oder in Form von Kurzglasfasern mit einer Länge von im allgemeinen 0,05 bis 1,5 mm erfolgen. Nach der Verarbeitung ist eine mittlere Faserlänge von 0,05 bis 5 mm optimal.

Als teilchenförmige Füllstoffe seien hier nur stellvertretend Glaskugeln, Quarzmehl, Bornitrid, Kaolin, Calciumcarbonat, Glimmer, Magnesiumcarbonat (Kreide) und Titandioxid genannt, wovon Titandioxid und Kaolin im allgemeinen bevorzugt werden.

Die erfindungsgemäßen Formmassen können weiterhin als Komponente (D) Flammschutzmittel in Mengen von 0 bis 20 Gew.-%, bevorzugt 5 bis 20 Gew.-%, insbesondere von 5 bis 15, bezogen auf das Gesamtgewicht der Formmassen enthalten.

Es kommen alle bekannten Flammschutzmittel in Betracht, wie Polyhalogendiphenyl, Polyhalogendiphenylether, Polyhalogenphthalsäure und ihre Derivate, Polyhalogenoligo- und -polycarbonate, wobei die entsprechenden Bromverbindungen besonders wirksam sind.

Beispiele hierfür sind Polymere des 2,6,2',6'-Tetrabrombisphenols A der Tetrabromphthalsäure, des 2,6-Dibromphenols und 2,4,6-Tribromphenols und deren Derivate.

Weitere halogenhaltige Flammschutzmittel sind Tetrabrombenzol, Hexachlorbenzol und Hexabrombenzol sowie halogenierte Polystrole und Polyphenylenether. Auch halogenierte Phthalimide können verwendet werden. Von diesen hat insbesondere N,N'-Ethylenbistetrabromphthalimid Bedeutung erlangt.

Bevorzugtes Flammschutzmittel (D) ist elementarer roter Phosphor, insbesondere dann, wenn die Formmassen glasfsaerverstärkt sind.

Es ist zwar möglich den roten Phosphor unbehandelt einzusetzen, besonders eignen sich jedoch Flammschutzmittel, in denen der Phosphor oberflächlich mit niedermolekularen flüssigen Substanzen wie Silikonöl, Paraffinöl oder Estern der Phthalsäure oder Adipinsäure oder mit polymeren oder oligomeren Verbindungen, z.B. mit Phenolharzen oder Aminoplasten sowie Polyurethanen beschichtet sind.

Außerdem sind Konzentrate von rotem Phosphor, z.B. in einem Polyamid oder Elastomeren als Flammschutzmittel geeignet. Insbesondere eignen sich Polyolefinhomo- und -copolymere als Konzentratpolymere. Bevorzugt werden Konzentrate mit einem möglichst hohen Phosphoranteil verwendet. Im allgemeinen beträgt der Phosphoranteil im Konzentrat nicht weniger als 30 Gew.%, bezogen auf das Gewicht des Konzentrates.

Die mittlere Teilchengröße ($d_{50}$) der in den Formmassen verteilten Phosphorpartikel liegt bevorzugt im Bereich von 0,0001 bis 0,5 mm, insbesondere von 0,001 bis 0,2 mm.

Geeignete Phosphorverbindungen als Flammschutzmittel sind Organophosphorverbindungen wie Phosphonate, Phosphinate, Phosphonate, Phosphinite, Phosphinoxide, Phosphine, Phosphite oder Phosphate sind ebenfalls bevorzugt. Als Beispiel sei Triphenylphosphinoxid genannt. Dieses kann allein oder vermischt mit Hexabrombenzol oder einem chlorierten Biphenyl oder rotem Phosphor und, wahlweise, Antimonoxid verwendet werden.

Typisch für die bevorzugten Phosphorverbindungen, die gemäß in der vorliegenden Erfindung verwendet werden können, sind solche der folgenden allgemeinen Formel

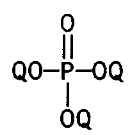

worin Q für Wasserstoff oder für gleiche oder verschiedene Kohlenwasserstoffreste oder Halogenkohlenwasserstoffreste, wie Alkyl, Cycloalkyl, Aryl, alkylsubstituiertes Aryl und arylsubstituiertes Alkyl steht, vorausgesetzt, daß mindestens einer der für Q stehenden Reste ein Arylrest ist. Beispiele solcher geeigneter Phosphate sind z.B. die folgenden: Phenylbisdodecylphosphat, Phenylbisneopentylphosphat, Phenylethylenhydrogenphosphat, Phenyl-bis-(3-5,5'-trimethylhexylphosphat), Ethyldiphenylphosphat, 2-Ethylhexyldi(p-tolyl)phosphat, Diphenylhydrogenphosphat, Bis-(2-ethylhexyl)phenylphosphat, Tri(nonylphenyl)phosphat, Phenylmethylhydrogenphosphat, Di(dodecyl)-p-tolylphosphat, Tricresylphosphat, Triphenylphosphat, Dibutylphenylphosphat und Diphenylhydrogenphosphat. Die bevorzugten Phosphate sind solche, bei denen jedes Q Aryl ist. Das am meisten bevorzugte Phosphat ist Triphenylphosphat. Weiter ist die Kombination von Triphenylphosphat mit Hexabrombenzol und Antimontrioxid bevorzugt.

Als Flammschutzmittel sind auch solche Verbindungen geeignet, die Phosphor-Stickstoff-Bindungen enthalten, wie Phosphonnitrilchlorid, Phosphorsäureesteramide, Phosphorsäureesteramine, Phosphorsäureamide, Phosphonsäureamide, Phosphinsäinreamide, Tris(Aziridinyl)-phosphinoxid oder Tetrakis-(hydroxymethyl)phosphoniumchlorid. Diese entflammungshemmenden Additive sind größtenteils im Handel erhältlich.

Neben den wesentlichen Komponenten können die erfindungsgemäßen Formmassen als Komponente (E) Zusatzstoffe und Verarbeitungshilfsmittel enthalten. Deren Anteil beträgt im allgemeinen bis zu 10 Gew.-%, vorzugsweise bis zu 5 Gew.-%, besonders bevorzugt von 0,5 bis 2 Gew.%, bezogen auf das Gesamtgewicht der Formmassen.

Zusatzstoffe, die üblicherweise verwendet werden sind z.B. Oxidationsverzögerer, Wärmestabilisatoren, Mittel gegen die Zersetzung durch Licht, Färbemittel, Farbstoffe, Pigmente, Weichmacher, Gleit- und Entformungshilfsmittel sowie Synergisten für Flammschutzmittel.

Oxidationsverzögerer und Wärmestabilisatoren, die den thermoplastischen Massen gemäß der Erfindung zugesetzt werden können, sind z.B. Halogenide von Metallen der Gruppe I des Periodensystems, z.B. Natrium-, Kalium-, Lithium-Halogenide, ggf. in Verbindung mit Kupfer-(I)-Halogeniden, z.B. Chloriden, Bromiden oder Iodiden. Weiterhin können Zinkfluorid und Zinkchlorid verwendet werden. Ferner sind sterisch gehinderte Phenole, Antitropfmittel, z.B. Polytetrafluorethylen, Hydrochinone, substituierte Vertreter dieser Gruppe und Mischungen dieser Verbindungen, vorzugsweise in Konzentrationen bis zu 1 Gew.-%, bezogen auf das Gewicht der Mischung, einsetzbar.

Daneben kommen, insbesondere für Copolyamide (A), die neben den olefinischen Doppelbindungen auch aromatische Einheiten aufweisen, Stabilisatoren auf der Basis von aromatischen, sekundären Aminen wie Diphenylamin und dessen Derivaten in Betracht.

Beispiele für UV-Stabilisatoren sind verschiedene substituierte Resorcine, Salicylate, Benzotriazole, Benzophenone und auch sterisch gehinderte Amine, sogenannte HALS, die im allgemeinen in Mengen bis zu 2 Gew.-% eingesetzt werden.

Gleit- und Entformungsmittel, die in der Regel in Mengen bis zu 1 Gew.-% der Formmasse zugesetzt werden, sind z.B. langkettige Fettsäuren wie Palmitinsäure oder Stearinsäure und ihre Salze bzw. Alkylester und -Amide, langkettige Alkohole wie Stearylalkohol, sowie Ester des Pentaerythrits mit langkettigen Fettsäuren.

Unter den Zusatzstoffen sind auch Synergisten für Flammschutzmittel wie Stabilisatoren, die die Zersetzung des roten Phosphors in Gegenwart von Feuchtigkeit und Luftsauerstoff verhindern. Als Beispiele seien Verbindungen des Cadmiums, Zinks, Aluminiums, Silbers, Eisens, Kupfers, Antimons, Zinns, Magnesiums, Mangans, Vanadiums, Bors und Aluminiums genannt. Besonders geeignete Verbindungen sind z.B. Oxide der genannten Metalle, ferner Carbonate oder Oxicarbonate, Hydroxide sowie Salze organischer oder anorganischer Säuren wie Acetate oder Phosphate bzw. Hydrogenphosphate und Sulfate.

Zur Herstellung der Copolyamide (A) eignen sich sowohl diskontinuierliche als auch kontinuierliche Verfahren. Zur Herstellung von Copolyamiden, die neben olefinischen Doppelbindungen auch aromatische Einheiten, bevorzugt mehr als 50 Mol.%, aufweisen und deren Einheiten ganz oder teilweise aus Dicarbonsäuren erhältlich sind, haben sich Verfahren als besonders vorteilhaft erwiesen, bei denen bei erhöhten Drucken und Temperaturen zwischen ca. 200 bis 400 °C und kurzen Verweilzeiten, bevorzugt kürzer als 15 Minuten, zunächst Präpolymere hergestellt werden, die anschließend in fester oder flüssiger Phase auf Endviskosität nachkondensiert werden. Durch diese kurze Verweilzeiten können Nebenreaktionen wie die Selbstkondensation von Diaminen zu Triaminen zurückgedrängt werden.

Die erfindinngsgemäßen Formmassen können z.B. nach an sich bekannten Verfahren hergestellt werden, indem man die Ausgangskomponenten in üblichen Mischvorrichtungen wie Schneckenextrudern vorzugsweise Zweischneckenextruder, Brabender-Mühlen oder Banburry-Mühlen sowie Knetern mischt und anschließend extrudiert. Nach der Extrusion wird das Extrudat abgekühlt und zerkleinert.

Um eine möglichst homogene Formmasse zu erhalten, ist eine intensive Durchmischung vorteilhaft. Dazu sind im allgemeinen mittlere Mischzeiten von 0,2 bis 30 Minuten bei Temperaturen von 280 bis 380 °C erforderlich. Die Abmischreihenfolge der Komponenten kann variiert werden, so können zwei oder falls gewünscht drei Komponenten vorgemischt werden, es können aber auch alle Komponenten gemeinsam gemischt werden.

Aus den so erhaltenen Formmassen lassen sich Formkörper oder flächige Gebilde wie Fasern und Folien herstellen, wozu z.B. bekannte Verfahren wie Extrusion oder Spritzguß, angewandt werden können. Anschließend können die Formkörper oder flächigen Gebilde energiereicher Strahlung ausgesetzt werden, wodurch die ihnen zugrunde liegenden Formmassen vernetzt werden. Im allgemeinen enthalten die vernetzten Produkte weniger als 50 %, insbesondere weniger als 30 % der ursprünglichen olefinischen Doppelbindungen. Unter energiereicher Strahlung ist z.B. Beta-, Gamma- oder Elektronenstrahlung sowie Röntgenstrahlung zu verstehen. Hierbei wird die Strahlung nach der gewünschten Eindringtiefe in das Material ausgewählt. UV-Strahlung ist aufgrund ihrer geringen Eindringtiefe in teilkristalline und daher nicht transparente Formkörper ungeeignet. Bevorzugt werden Elektronenstrahlen von 20 bis 200, insbesondere 50 bis 100 kGray verwendet. Die Elektronenstrahlen können beispielsweise mittels van der Graaf-Generatoren mit Beschleunigerspannungen von 300 bis 3000, bevorzugt 800 bis 2000 keV erzeugt werden, wobei die Energie umso höher gewählt wird, je größer die erforderliche Eindringtiefe in das Formteil ist.

Die Gesamtbestrahlungszeit liegt im allgemeinen im Bereich von 1 bis 60, bevorzugt von 5 bis 30 s. Die Formkörper oder flächigen Gebilde können dabei ununterbrochen bestrahlt oder mehrmals für kürzere Zeit bestrahlt werden, bis die gewünschte Gesamtbestrahlungszeit erreicht ist. Mit Elektronenstrahlen können üblicherweise Teile bis zu einer Dicke von etwa 20 cm, bevorzugt 10 cm, ausgehärtet werden. Dies entspricht bei beidseitiger Bestrahlung einer Eindringtiefe von ca. 10 bzw. ca. 5 cm.

Es ist auch möglich, die Formkörper oder flächigen Gebilde Gammastrahlung auszusetzen, die von radioaktiven Nukliden erzeugt werden. Mit Gammastrahlen werden Eindringtiefen von mehreren Metern erreicht, so daß die Dicke der zu vernetzenden Teile praktisch keiner Einschränkung unterliegt. Die Bestrahlungszeiten bei Gammastrahlung liegen im allgemeinen im Bereich von 0,1 bis 100 Stunden; bevorzugt von 1 bis 20 Stunden.

Die vernetzten Produkte Zeichnen sich insbesondere durch sehr gute Wärmeformbeständigkeiten aus. Formkörper, Fasern oder Folien, die nach dem erfindinngsgemäßen Verfahren hergestellt wurden, eignen sich daher insbesondere für Einsatzbereiche, in denen sie hohen thermischen Belastungen genügen sollen, so z.B. auf dem Elektronikgebiet.

Beispiele

Abkürzungen

| | |
|---|---|
| AS | Adipinsäure |
| HMD | Hexamethylendiamin |
| CL | ε-Caprolactam |
| HDS | 3-Hexendicarbonsäure |
| OS | 4-Octen-1,8-dicarbonsäure |
| DDO | 2,7-Diamino-2,7-dimethyl-4-octen |
| ES | 10-Eicosen-1,20-dicarbonsäure |

Arbeitsvorschrift

Beispiel Ia

144 g (1 Mol) 3-Hexen-1,6-dicarbonsäure (HDS) und 116 g (1 Mol) Hexamethylendiamin (HMD) wurden in 300 ml heißem Wasser gelöst. Beim Abkühlen kristallisierte ein 1:1-Addukt HDS/HMS aus. Entsprechend wurde ein Umsetzungsprodukt aus Adipinsäure (AS) und Hexamethylendiamin HMD hergestellt.

In einem 1-1-Laborautoklaven wurden 13 g HDS/HMD, 118 g AS/HMD und 20 g Wasser vorgelegt. Dann wurde der Autoklav innerhalb einer Stunde auf 280 °C geheizt, wobei der Druck ab Erreichen von 20 bar durch Entspannen von Wasserdampf konstant gehalten wurde. Anschließend wurde noch 2 Stunden bei 280 °C und 20 bar kondensiert. Dann wurde innerhalb eines Zeitraums von 2 Stunden kontinuierlich auf Atmosphärendruck entspannt. Das so erhaltene Produkt wurde ausgetragen, verstrangt, granuliert und 8 Stunden bei 80 °C im Vakuum getrocknet.

Beispiele 1b bis 5

Diese Polyamide wurden entsprechend der oben angegebenen Vorschrift hergestellt, wobei caprolactamhaltige Produkte nach der Kondensation dreimal je 8 Stunden mit 90 °C heißem Wasser extrahiert wurden.

Bestrahlung der Formkörper 1 bis 5

Aus den Formmassen gespritzte Probekörper (10x10x3 mm) wurden einseitig mit einer Strahlendosis von 100 kGray, erzeugt mit einem Van der Graaf-Generator mit einer Beschleunigungsspannung von 3 MV, bestrahlt. Die Probekörper wurden jeweils dreimal je 10 s lang bestrahlt, wobei zwischen den Bestrahlungsdurchgängen jeweils 5 min liegen. Die Bestrahlung wurde bei Raumtemperatur durchgeführt. Während der Bestrahlung erwärmten sich die Probekörper auf etwa 60 °C.

Prüfungen

Die Viskositätszahl (VZ) unbestrahlter Proben wurde an 0,5 %igen Lösungen in 96%iger Schwefelsäure nach ISO 307 bestimmt.

Ein Maß für den Vernetzungsgrad, der durch das Bestrahlen erreicht wurde, ist der unlösliche Anteil, der nach der Extraktion der löslichen Anteile aus der bestrahlten Probe, zurückbleibt. Dazu wurden zunächst Spanproben (Dicke nicht mehr als 0,02 mm, Gewicht etwa 0,2 g) oder Schnittproben mit möglichst großer Oberfläche (Gewicht etwa 1,0 g) hergestellt und mit einer Genauigkeit von 1 mg gewogen.

Anschließend wurden die Spanproben mit 50 ml, die Schnittproben mit 150 ml Ameisensäure 6 Stunden lang extrahiert. Danach wurde die Lösung entfernt, der unlösliche Anteil gesammelt, getrocknet und gewogen.

Die Wärmeformbeständigkeit sowohl vor als auch nach dem Bestrahlen wurde an gepreßten Probekörpern (10 x 10 x 3 mm) nach DIN 53 460 bestimmt. Dazu wurden die Probekörper in einem Ölbad, das bis max. 250 °C erwärmt werden konnte, erhitzt, mit 10 N (Vicat A) belastet und die Temperatur bei der Solleindringtiefe von 1 mm gemessen.

Die jeweiligen Zusammensetzungen und die Ergebnisse der Prüfungen sind der Tabelle zu entnehmen.

Tabelle: Zusammensetzung der Proben und Meßergebnisse

| Beispiel Nr. | Zusammensetzung [Mol-%] | | | VZ1) [ml/g] | unlöslicher Anteil2) [%] | Vicat A vor Bestrahlung [°C] | Vicat A nach Bestrahlung [°C] |
|---|---|---|---|---|---|---|---|
| 1v* | - | 100 AS/HMD | - | 149 | 0 | 245 | 244 |
| 1a | 2 HDS/HMD | 98 AS/HMD | - | 155 | 1,5 | 243 | 249 |
| 1b | 5 HDS/HMD | 95 AS/HMD | - | 144 | 10 | 224 | >250 |
| 1c | 10 HDS/HMD | 90 AS/HMD | - | 142 | 22 | 192 | >250 |
| 1d | 20 HDS/HMD | 80 AS/HMD | - | 135 | 40 | 178 | >250 |
| 2v* | - | - | 100 CL | 155 | 0 | 217 | 215 |
| 2a | 2 HDS/HMD | - | 98 CL | 139 | 0,5 | 215 | 235 |
| 2b | 10 HDS/HMD | - | 90 CL | 160 | 14 | 199 | >250 |
| 3a | 10 AS/DDO | 90 AS/HMD | - | 133 | 20 | 209 | 239 |
| 3b | 20 AS/DDO | 80 AS/HMD | - | 129 | 39 | 196 | >250 |
| 3c | 10 AS/DDO | - | 90 CL | 140 | 28 | 176 | 230 |
| 4 | 10 OS/HMD | 90 AS/HMD | - | 141 | 15 | 201 | 249 |
| 5 | 10 ES/HMD | 90 AS/HMD | - | -3) | 52 | 175 | >250 |

* zum Vergleich
1) vor Bestrahlung
2) nach Bestrahlung
3) nicht meßbar

## Patentansprüche

1. Formmassen aus
   A) 40 bis 100 Gew.-% eines Copolyamids auf der Basis von
      $a_1$) 1 bis 20 Mol-%, bezogen auf das Copolyamid, mindestens eines Monomeren, welches mindestens eine olefinische Doppelbindung enthält (Monomeres $a_1$), aus der Gruppe der
         $\alpha_1$) olefinisch ungesättigten Lactame,
         $\alpha_2$) olefinisch ungesättigten Aminocarbonsäuren,
         $\alpha_3$) olefinisch ungesättigten Dicarbonsäuren,
         $\alpha_4$) olefinisch ungesättigten Diamine und
      $a_2$) 80 bis 99 Mol-%, bezogen auf das Copolyamid, mindestens eines Monomeren, welches keine olefinischen Doppelbindungen enthält (Monomeres $a_2$), aus der Gruppe der
         $\beta_1$) Lactame,
         $\beta_2$) Aminocarbonsäuren,
         $\beta_3$) Dicarbonsäuren,
         $\beta_4$) Diamine und
   B) 0 bis 35 Gew.-% eines schlagzäh modifizierenden Kautschuks und
   C) 0 bis 50 Gew.-% eines Füllstoffes und/oder eines Verstärkungsmittels und
   D) 0 bis 20 Gew.-% eines Flammschutzmittels und
   E) 0 bis 10 Gew.-% weiterer Zusatzstoffe und Verarbeitungshilfsmittel.

2. Formmassen nach Anspruch 1, in denen das Monomere ($a_1$) eine olefinisch ungesättigte Dicarbonsäure oder eine Mischung verschiedener ungesättigter Dicarbonsäuren ist und die Monomere ($a_2$) Adipinsäure und Hexamethylendiamin sind.

3. Formmassen nach Anspruch 1, in denen das Monomere ($a_1$) eine olefinisch ungesättigte Dicarbonsäure oder eine Mischung verschiedener ungesättigter Dicarbonsäuren ist und die Monomere ($a_2$) Hexamethylendiamin und $\epsilon$-Caprolactam sind.

4. Formmassen nach den Ansprüchen 1 bis 3, in denen die olefinisch ungesättigte Dicarbonsäure ($\alpha_3$) 3-Hexen-1,6-dicarbonsäure, 4-Octen-1,8-dicarbonsäure, 10-Eicosen-1,20-dicarbonsäure oder eine Mischung dieser Säuren ist.

5. Formmassen nach den Ansprüchen 1 oder 4, in denen das olefinisch ungesättigte Diamin ($\alpha_4$) 3-Hexen-1,6-diamin oder 2,7-Diamino-2,7-dimethyl-4-octen oder eine Mischung dieser Diamine ist.

6. Verwendung der Formmassen gemäß den Ansprüchen 1 bis 5 zur Herstellung von Formkörpern oder flächigen Gebilden.

7. Formkörper oder flächige Gebilde erhältlich aus den Formmassen gemäß den Ansprüchen 1 bis 5.

8. Verfahren zur Herstellung der Formkörper oder flächigen Gebilde gemäß Anspruch 7, dadurch gekennzeichnet, daß die Formmassen nach den Ansprüchen 1 bis 5 nach der Formgebung energiereicher Strahlung ausgesetzt werden.

Europäisches Patentamt

# EUROPÄISCHER RECHERCHENBERICHT

Nummer der Anmeldung

EP 93 10 2914

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | FR-A-2 466 477 (SNIA VISCOSA)<br>--- | | C 08 L 77/00<br>C 08 L 77/06<br>C 08 G 69/02<br>C 08 G 69/26<br>G 03 F 7/038 |
| A | FR-A-2 628 112 (CENTRAL GLASS)<br>& DE-A-3 906 684 (CENTRAL GLASS) (Kat. D)<br>--- | | |
| D,A | POLYMER, Band 17, Nr. 3, März 1976, Seiten 185-191; G. MAGLIO et al.: "Influence of intra-chain trans double bonds on the melt crystallization of polyamides"<br>----- | | |
| | | | RECHERCHIERTE SACHGEBIETE (Int. Cl.5) |
| | | | C 08 L<br>C 08 G<br>G 03 F |

Der vorliegende Recherchenbericht wurde für alle Patentansprüche erstellt

| Recherchenort | Abschlußdatum der Recherche | Prüfer |
|---|---|---|
| DEN HAAG | 06-07-1993 | LEROY A J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)